# EUROPEAN PATENT APPLICATION

(11) **EP 4 819 416 A1**
(43) Date of publication of application: **07.10.2026**
(21) Application number: 26168821.2
(22) Date of filing: 30.03.2026
(51) Int. Cl.: H01R 43/20, H01R 12/58, H05K 3/306

(54) **TERMINAL ROTATING DEVICE AND TERMINAL PLUGGING SYSTEM**

(30) Priority: 01.04.2025 CN 202510405510
(71) Applicant: Tyco Electronics (Shanghai) Co., Ltd., Pilot Free Trade Zone Shanghai 200131 (CN)
(72) Inventor: Zhu, Yiqun, Shanghai, 200233 (CN); Meng, Qiao, Shanghai, 200233 (CN); Wang, Zhen, Shanghai, 200233 (CN); Hei, Yuwen, Shanghai, 200233 (CN); Zhang, Dan, Suzhou, 32 215123 (CN)
(74) Representative: Grünecker Patent- und Rechtsanwälte PartG mbB

(57) **Abstract**

The present invention discloses a terminal rotating device and a terminal plugging system. The terminal rotating device comprises: a rotating disc (10) with four evenly spaced engagement slots (11) distributed in its circumferential direction; and a driving shaft (100), connected to the rotating disc (10), for driving the rotating disc (10) to rotate around its central axis. The engagement slot (11) of the rotating disk (10) is adapted to engage with a carrier strip part (84) on a terminal (80), and the rotating disk (10) is used to rotate the terminal (80) engaged with it from a first posture to a second posture perpendicular to the first posture, so as to rotate a plug pin (82) of the terminal (80) from a horizontal orientation to a vertical orientation. In the present invention, the terminal rotating device can rotate the plug pin of the L-shaped right angle terminal from a horizontal orientation to a vertical orientation, so that the terminal plugging system can not only be used for inserting straight terminals, but also for inserting L-shaped right angle terminals, expanding the application scope of the terminal plugging system.

## Description

### CROSS-REFERENCE TO RELATED APPLICATION

This application claims the benefit of Chinese Patent Application No. CN202510405510.5 filed on April 1, 2025 in the State Intellectual Property Office of China, the whole disclosure of which is incorporated herein by reference.

### BACKGROUND OF THE INVENTION

### Field of the Invention

The present invention relates to a terminal rotating device and a terminal plugging system comprising the terminal rotating device.

### Description of the Related Art

In the prior art, a terminal plugging system typically includes a conveying device for transporting a terminal strip, a cutting device for cutting terminals off the terminal carrier strip, and a grasping device for grasping the cut terminals. When the terminals on the conveyed terminal strip are straight terminals, the plug pins of the terminals will initially be in a vertical position. Therefore, after grasping the terminal, the grasping device can vertically insert the plug pin of the terminal into a socket in a circuit board. However, when the terminals on the conveyed terminal strip are L-shaped right angle terminals, the plug pins of the terminals are initially in a horizontal position. Therefore, after grasping the terminal, the grasping device cannot insert the plug pin of the terminal into the socket in the circuit board in the vertical direction. Therefore, the existing terminal plugging system cannot be used to plug L-shaped right angle terminals, which limits its application range.

### SUMMARY OF THE INVENTION

The present invention has been made to overcome or alleviate at least one aspect of the above mentioned disadvantages.

According to an aspect of the present invention, there is provided a terminal rotating device. The terminal rotating device comprises: a rotating disc with four evenly spaced engagement slots distributed in its circumferential direction; and a driving shaft, connected to the rotating disc, for driving the rotating disc to rotate around its central axis. The engagement slot of the rotating disk is adapted to engage with a carrier strip part on a terminal, and the rotating disk is used to rotate the terminal engaged with it from a first posture to a second posture perpendicular to the first posture, so as to rotate a plug pin of the terminal from a horizontal orientation to a vertical orientation.

According to an exemplary embodiment of the present invention, the engagement slot has an elastic cantilever located on one side, which is used to clamp and fix the carrier strip part of the terminal inserted into the engagement slot in the engagement slot.

According to another exemplary embodiment of the present invention, an arc-shaped protrusion is formed at the end of the elastic cantilever, which is used to guide the carrier strip part of the terminal into the engagement slot and to rest against the inserted carrier strip part.

According to another exemplary embodiment of the present invention, a mounting hole is formed in the rotating disk, and the end of the driving shaft is inserted into the mounting hole of the rotating disk, and the cross-section of the mounting hole and the end of the driving shaft is non-circular.

According to another exemplary embodiment of the present invention, the terminal rotating device further comprises a driver connected to the driving shaft for driving the driving shaft to rotate, the driver drives the driving shaft to rotate 90 degrees around its central axis each time, to rotate the terminal engaged with the rotating disk from the first posture to the second posture perpendicular to the first posture.

According to another aspect of the present invention, there is provided a terminal plugging system. The terminal plugging system comprises: the above terminal rotating device used for rotating a terminal engaged to it from a first posture to a second posture perpendicular to the first posture; a conveying device for conveying a terminal strip towards the rotating disk and inserting the carrier strip part of a first terminal at the front end of the terminal strip into the engagement slot of the rotating disk; a cutting device for cutting off the first terminal at the front end of the terminal strip from the terminal strip and cutting off the carrier strip part on the terminal that has been rotated to the second posture by the rotating disk; and a grasping device which is used to grasp the terminal that has been rotated to the second posture and to vertically insert the plug pin of the grasped terminal into a socket in a circuit board, the terminal on the terminal strip conveyed by the conveying device is in the first posture, and the plug pin of the terminal is in a horizontal orientation when the terminal is in the first posture, and the plug pin of the terminal is in a vertical orientation when the terminal is in the second posture.

According to an exemplary embodiment of the present invention, the conveying device comprises: a conveying gear with teeth for meshing with the positioning slots on the terminal strip; and a drive motor, connected to the conveying gear, for driving the conveying gear to rotate. The terminal strip is adapted to be moved in a predetermined conveying direction under the drive of the conveying gear, and the tooth pitch between adjacent two teeth on the conveying gear is equal to the spacing between adjacent two terminals on the terminal strip.

According to another exemplary embodiment of the present invention, the conveying device further comprises a conveying channel extending along the predetermined conveying direction, used to guide the terminal strip to move along the predetermined conveying direction, the terminal strip is positioned in a movable manner in the conveying channel, such that the terminals on the conveyed terminal strip are in the first posture.

According to another exemplary embodiment of the present invention, the cutting device comprises a cutting tool located on one side of the rotating disk and having a first cutting part and a second cutting part, the cutting tool can be moved relative to the rotating disk between an initial position and a cutting position. When the cutting tool is moved to the cutting position, the first cutting part cuts off the first terminal at the front end of the terminal strip from the terminal strip, while the second cutting part cuts off the carrier strip part on the terminal that has been rotated to the second posture by the rotating disk.

According to another exemplary embodiment of the present invention, before the cutting tool is moved to the cutting position, the grasping device grasps the terminal that has been rotated to the second posture by the rotating disk to ensure that the terminal remains stationary when cutting off the carrier strip part on the terminal.

According to another exemplary embodiment of the present invention, the cutting device further comprises a driving mechanism which is connected to the cutting tool, the driving mechanism is used to drive the cutting tool to move between the initial position and the cutting position.

According to another exemplary embodiment of the present invention, a positioning post is formed on the cutting tool, and a positioning hole that cooperates with the positioning post is formed in the rotating disk; the central axis of the positioning hole is parallel to the central axis of the rotating disk to ensure that the cutting tool is moved in a direction parallel to the central axis of the rotating disk.

According to another exemplary embodiment of the present invention, the terminal plugging system further comprises an elastic pressing device located on the other side of the rotating disk opposite to the cutting tool, the elastic pressing device is pressed against a second terminal at the front end of the terminal strip to ensure that after the first terminal at the front end of the terminal strip is cut off from the terminal strip by the first cutting part, the front end of the terminal strip can automatically reset under the push of the elastic pressing device.

According to another exemplary embodiment of the present invention, the elastic pressing device comprises: a pushing block which is pressed against the second terminal at the front end of the terminal strip; and a reset spring which applies an elastic reset force on the pushing block.

According to another exemplary embodiment of the present invention, the terminal plugging system further comprises a waste recycling device for recycling the carrier tape part cut from the terminal.

According to another exemplary embodiment of the present invention, the waste recycling device comprises: a vacuum adsorber with a compressed air inlet, a compressed air outlet, and a vacuum suction port; and a waste conveying pipe which is connected to the compressed air outlet of the vacuum adsorber. The vacuum suction port faces the carrier strip part on the terminal that has been rotated to the second posture, so that the carrier strip part cut from the terminal can be sucked into the vacuum adsorber, and the sucked carrier strip part is transported to a waste recycling bin through the waste conveying pipe.

According to another exemplary embodiment of the present invention, the second cutting part of the cutting tool is used to cut off the carrier strip part on the terminal and to push the cut carrier strip part into the vacuum suction port of the vacuum adsorber.

According to another exemplary embodiment of the present invention, the vacuum adsorber is installed on a fixed seat, and the reset spring is compressed between the vacuum adsorber and the pushing block.

According to another exemplary embodiment of the present invention, the terminal plugging system further comprises a position holding device adapted to be moved between a release position and a holding position. When it is not necessary to rotate the rotating disc, the position holding device is moved to the holding position to hold the rotating disc at a predetermined angular position; when it is necessary to rotate the rotating disc, the position holding device is moved to the release position to allow the rotating disc to rotate.

According to another exemplary embodiment of the present invention, the position holding device comprises: a brake block, suitable for frictional engagement with the driving shaft; and a brake spring which applies braking force to the brake block. When the position holding device is moved to the holding position, the brake block is pressed against the driving shaft to prevent rotation of the driving shaft and the rotating disc.

According to another exemplary embodiment of the present invention, the grasping device comprises: a gripper suitable for gripping and grasping a terminal that has been rotated to the second posture by the rotating disk; and a moving mechanism used to move the gripper and the terminal grabbed by the gripper.

According to another exemplary embodiment of the present invention, the moving mechanism is a three-axis translation mechanism or a multi degree of freedom robot.

According to another exemplary embodiment of the present invention, the terminal comprises: a plate-shaped body; a mating pin which is connected to the plate-shaped body for mating with a mating terminal; and a plug pin which is connected to the plate-shaped body and used to plug into a socket in a circuit board. The extension direction of the mating pin is perpendicular to the extension direction of the plug pin, so that the terminal is L-shaped, the grasping device grasps the terminal by clamping the plate-shaped body of the terminal, and the carrier strip part is connected to the plate-shaped body of the terminal.

In the aforementioned exemplary embodiments according to the present invention, the terminal rotating device is capable of rotating the plug pin of the L-shaped right angle terminal from a horizontal orientation to a vertical orientation, so that the terminal plugging system can not only be used for inserting straight terminals, but also for inserting L-shaped right angle terminals, expanding the application scope of the terminal plugging system.

### BRIEF DESCRIPTION OF THE DRAWINGS

The above and other features of the present invention will become more apparent by describing in detail exemplary embodiments thereof with reference to the accompanying drawings, in which:
Figure 1 shows an illustrative perspective view of a terminal plugging system according to an exemplary embodiment of the present invention;
Figure 2 shows an illustrative exploded view of a terminal plugging system according to an exemplary embodiment of the present invention;
Figure 3 shows another illustrative exploded view of a terminal plugging system according to an exemplary embodiment of the present invention;
Figure 4 shows another illustrative exploded view of a terminal plugging system according to an exemplary embodiment of the present invention;
Figure 5 shows another illustrative exploded view of a terminal plugging system according to an exemplary embodiment of the present invention;
Figure 6 shows an illustrative perspective view of a terminal plugging system according to an exemplary embodiment of the present invention when viewed from the front side;
Figure 7 shows an illustrative exploded view of a terminal plugging system according to an exemplary embodiment of the present invention when viewed from the front side;
Figure 8 shows a cross-sectional view of a terminal plugging system according to an exemplary embodiment of the present invention when viewed from the front side;
Figure 9 shows an illustrative enlarged view of the conveying device of a terminal plugging system according to an exemplary embodiment of the present invention;
Figure 10 shows an illustrative perspective view of a terminal rotating device and a terminal strip of a terminal plugging system according to an exemplary embodiment of the present invention, wherein the carrier strip part of the first terminal at the front end of the terminal strip has not yet been inserted into the engagement slot on the rotating disc;
Figure 11 shows an illustrative perspective view of a terminal rotating device and a terminal strip of a terminal plugging system according to an exemplary embodiment of the present invention, wherein the carrier strip part of the first terminal at the front end of the terminal strip has been inserted into the engagement slot on the rotating disc;
Figure 12 shows an illustrative perspective view of a terminal rotating device and a terminal strip of a terminal plugging system according to an exemplary embodiment of the present invention, wherein the carrier strip part of the first terminal at the front end of the terminal strip is inserted into the engagement slot on the rotating disc and a terminal cut from the terminal strip has been rotated to the second posture by the rotating disc;
Figure 13 shows an illustrative view of a terminal plugging system according to an exemplary embodiment of the present invention, in which the grasping device grasps the terminal that has been rotated to the second posture by the rotating disk and inserts the grasped terminal onto the circuit board;
Figure 14 shows an illustrative view of a terminal plugging system according to an exemplary embodiment of the present invention, in which a terminal cut from a terminal strip is rotated to a second posture by a rotating disk; and
Figure 15 shows an illustrative view of a terminal plugging system according to an exemplary embodiment of the present invention, in which the conveying device drives the terminal strip to move forward by one pitch to insert the carrier strip part of the first terminal at the front end of the terminal strip into the engagement slot on the rotating disc.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a terminal rotating device. The terminal rotating device comprises: a rotating disc with four evenly spaced engagement slots distributed in its circumferential direction; and a driving shaft, connected to the rotating disc, for driving the rotating disc to rotate around its central axis. The engagement slot of the rotating disk is adapted to engage with a carrier strip part on a terminal, and the rotating disk is used to rotate the terminal engaged with it from a first posture to a second posture perpendicular to the first posture, so as to rotate a plug pin of the terminal from a horizontal orientation to a vertical orientation.

According to another general concept of the present invention, there is provided a terminal plugging system. The terminal plugging system comprises: the above terminal rotating device used for rotating a terminal engaged to it from a first posture to a second posture perpendicular to the first posture; a conveying device for conveying a terminal strip towards the rotating disk and inserting the carrier strip part of a first terminal at the front end of the terminal strip into the engagement slot of the rotating disk; a cutting device for cutting off the first terminal at the front end of the terminal strip from the terminal strip and cutting off the carrier strip part on the terminal that has been rotated to the second posture by the rotating disk; and a grasping device which is used to grasp the terminal that has been rotated to the second posture and to vertically insert the plug pin of the grasped terminal into a socket in a circuit board, the terminal on the terminal strip conveyed by the conveying device is in the first posture, and the plug pin of the terminal is in a horizontal orientation when the terminal is in the first posture, and the plug pin of the terminal is in a vertical orientation when the terminal is in the second posture.

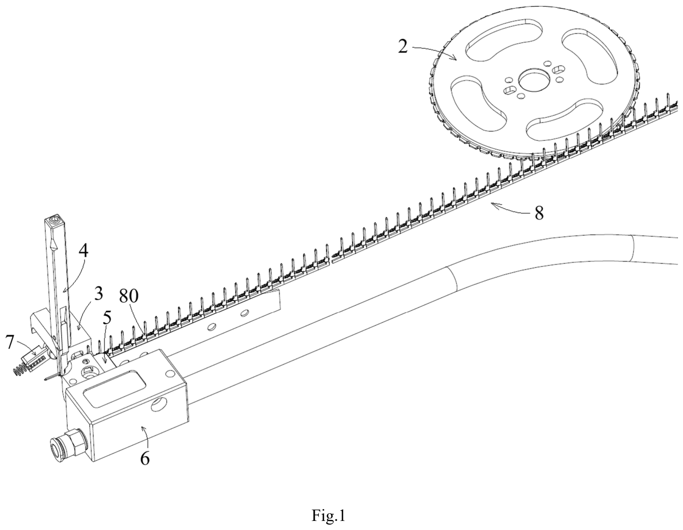

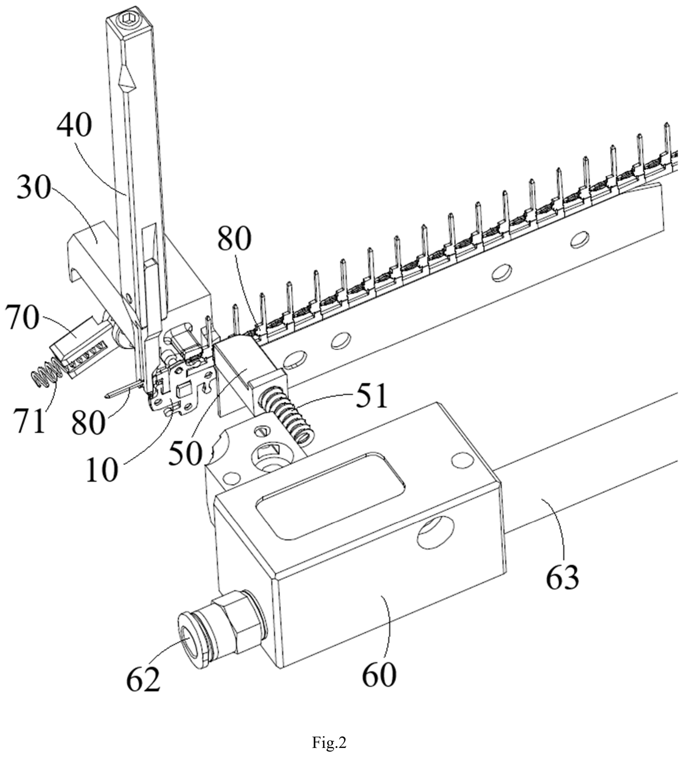

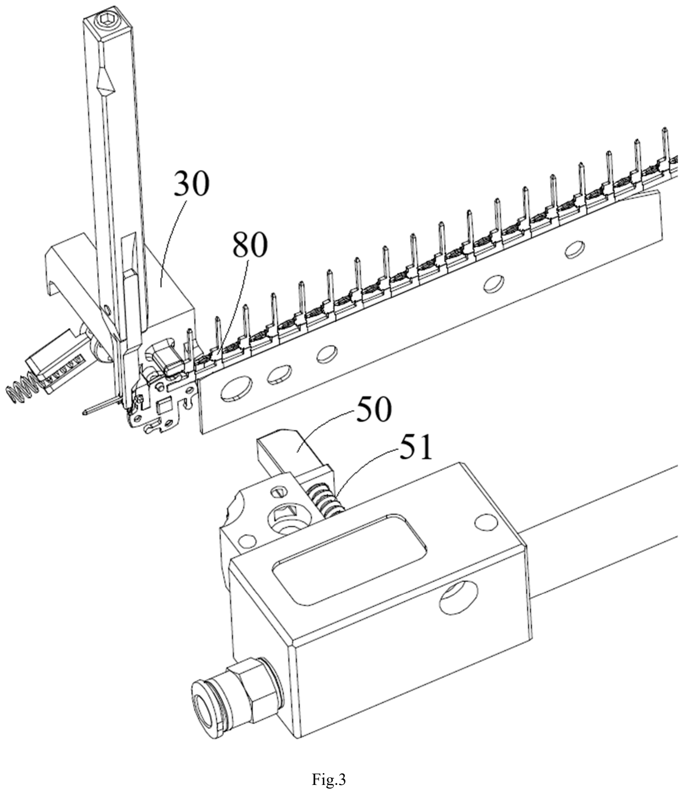

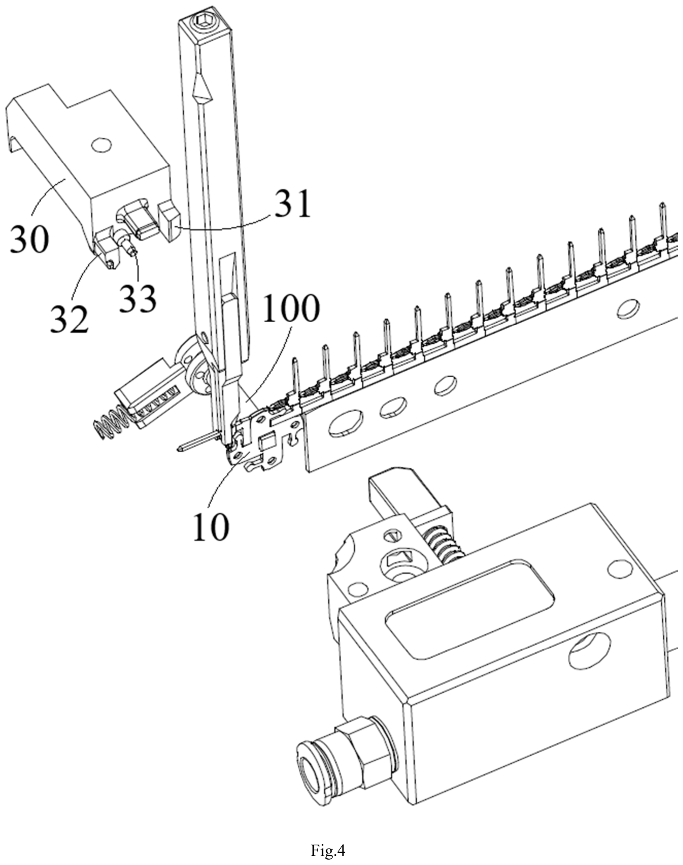

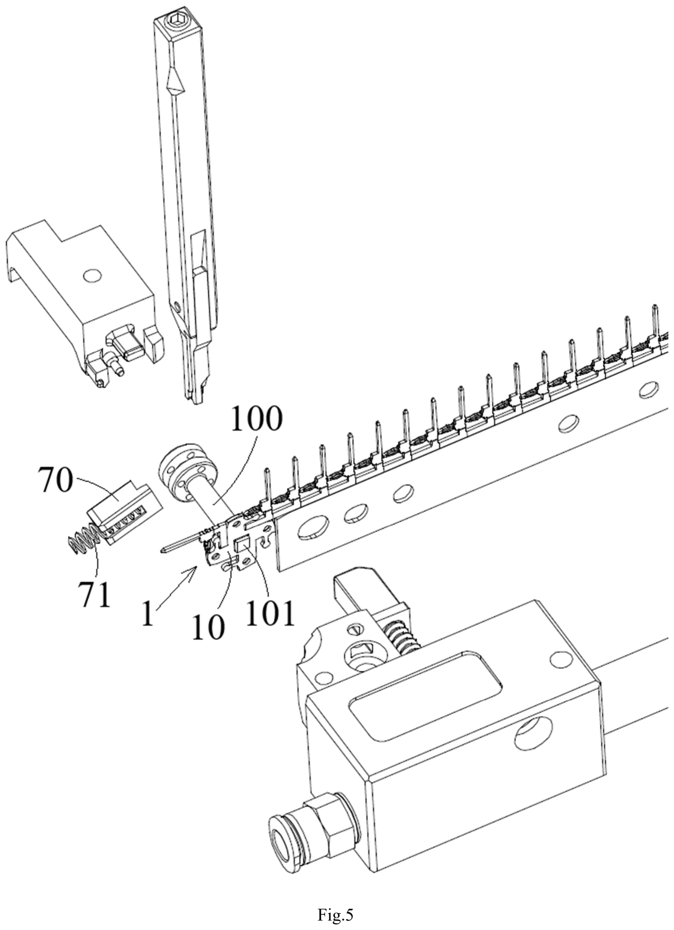

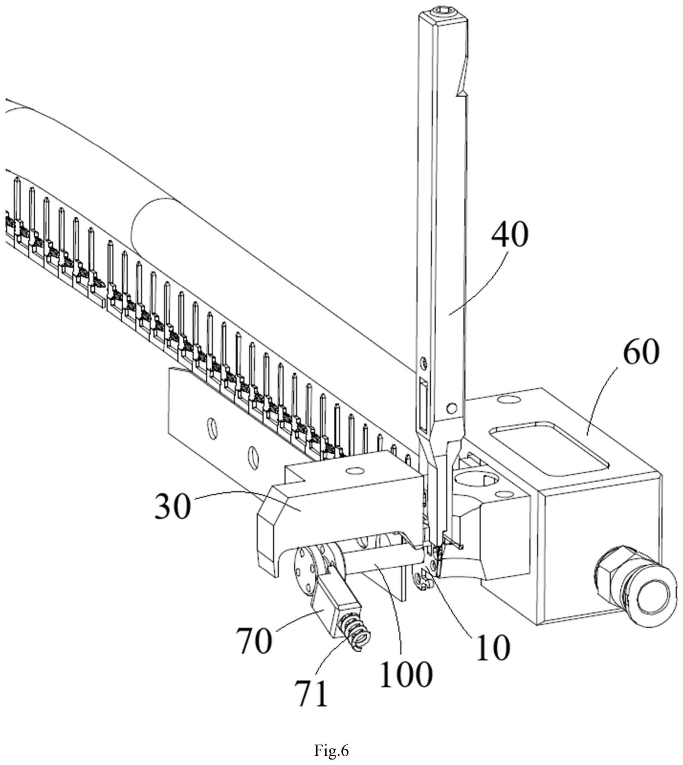

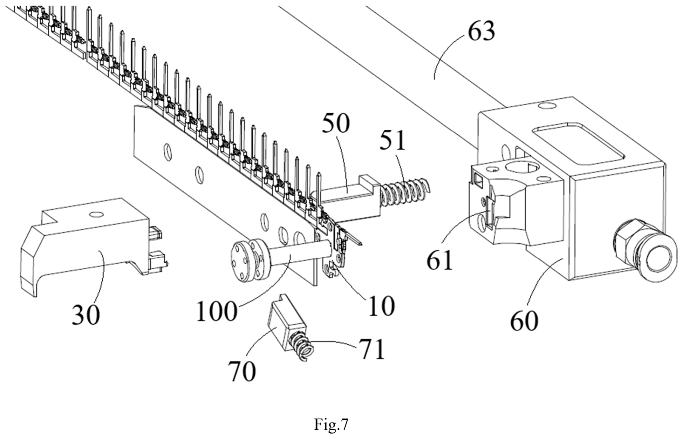

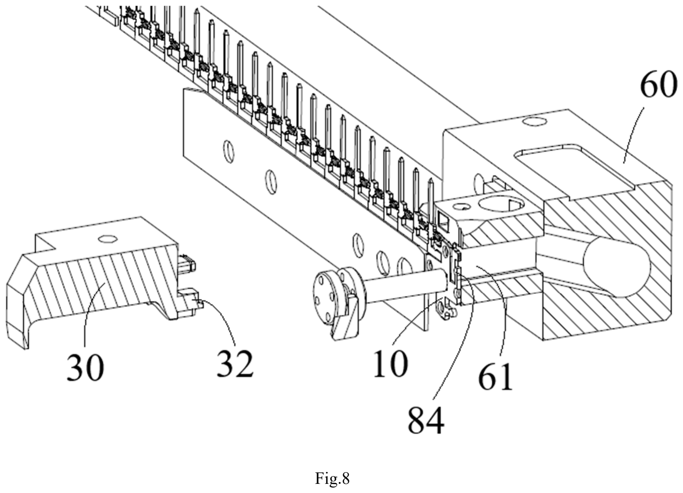

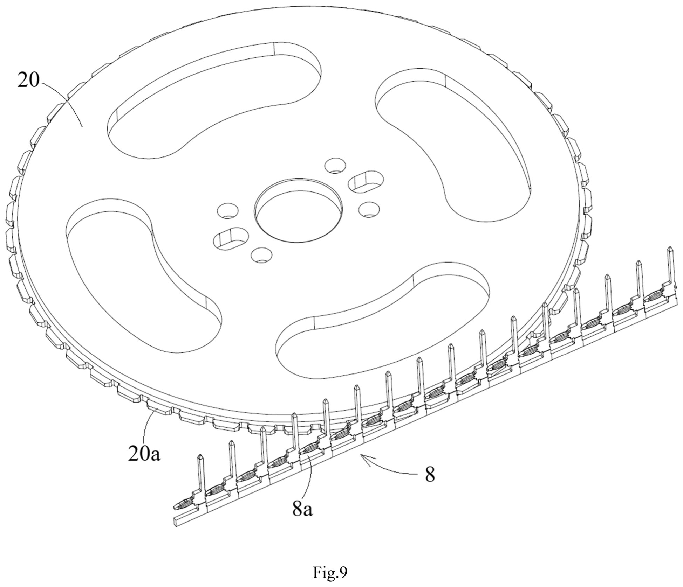

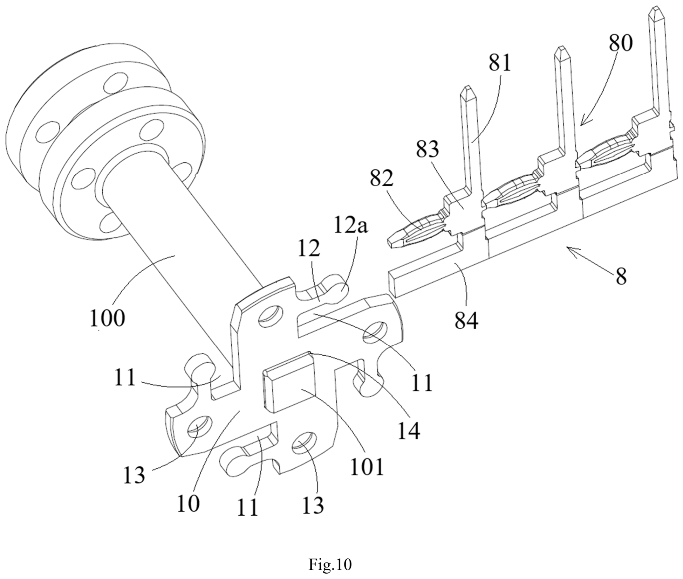

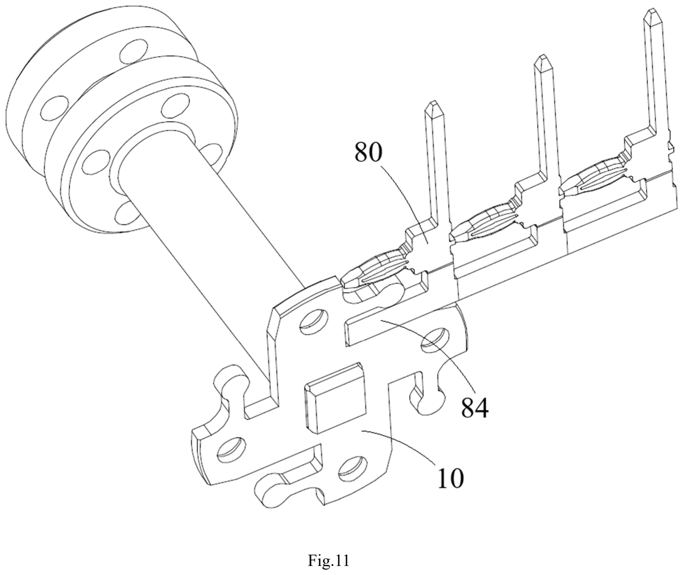

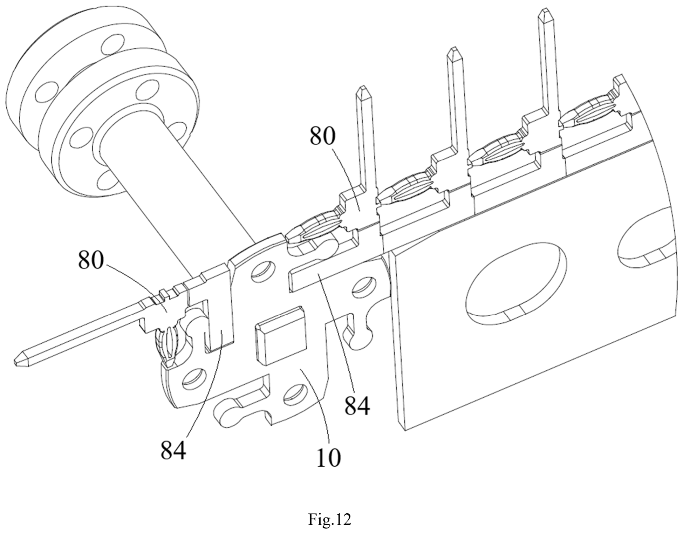

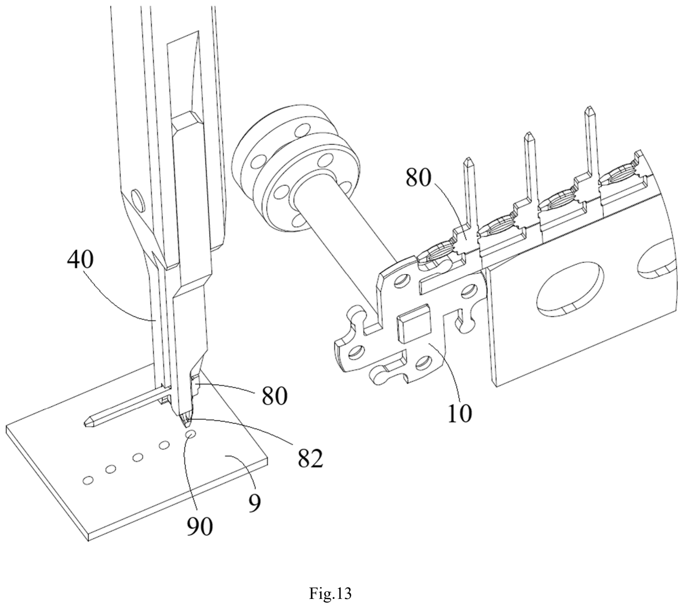

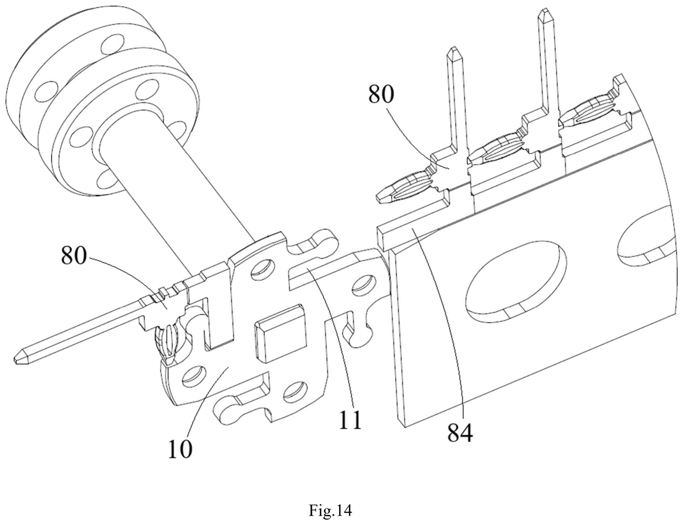

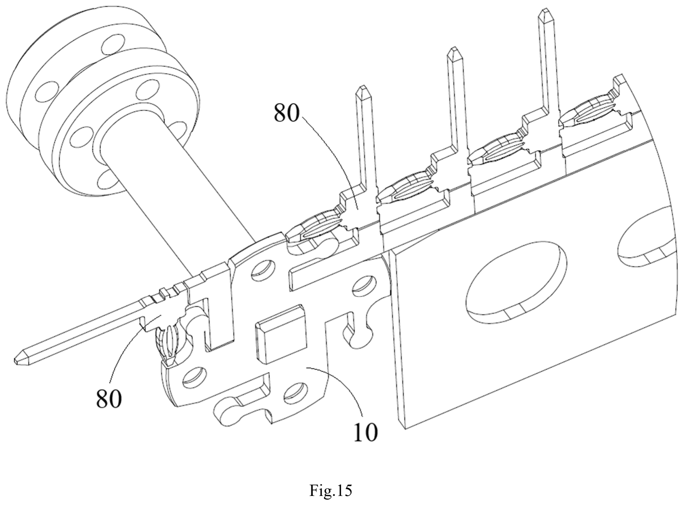

Figure 1 shows an illustrative perspective view of a terminal plugging system according to an exemplary embodiment of the present invention; Figure 2 shows an illustrative exploded view of a terminal plugging system according to an exemplary embodiment of the present invention; Figure 3 shows another illustrative exploded view of a terminal plugging system according to an exemplary embodiment of the present invention; Figure 4 shows another illustrative exploded view of a terminal plugging system according to an exemplary embodiment of the present invention; Figure 5 shows another illustrative exploded view of a terminal plugging system according to an exemplary embodiment of the present invention; Figure 6 shows an illustrative perspective view of a terminal plugging system according to an exemplary embodiment of the present invention when viewed from the front side; Figure 7 shows an illustrative exploded view of a terminal plugging system according to an exemplary embodiment of the present invention when viewed from the front side; Figure 8 shows a cross-sectional view of a terminal plugging system according to an exemplary embodiment of the present invention when viewed from the front side; Figure 9 shows an illustrative enlarged view of the conveying device 2 of the terminal plugging system according to an exemplary embodiment of the present invention; Figure 10 shows an illustrative perspective view of the terminal rotating device 1 and the terminal strip 8 of the terminal plugging system according to an exemplary embodiment of the present invention, wherein the carrier strip part 84 of the first terminal 80 at the front end of the terminal strip 8 has not yet been inserted into the engagement slot 11 on the rotating disk 10; Figure 11 shows an illustrative perspective view of the terminal rotating device 1 and the terminal strip 8 of the terminal plugging system according to an exemplary embodiment of the present invention, wherein the carrier strip part 84 of the first terminal 80 at the front end of the terminal strip 8 has been inserted into the engagement slot 11 on the rotating disk 10; Figure 12 shows an illustrative perspective view of a terminal rotating device 10 and a terminal strip 8 of a terminal plugging system according to an exemplary embodiment of the present invention, wherein the carrier strip part 84 of the first terminal 80 at the front end of the terminal strip 8 is inserted into the engagement slot 11 on the rotating disc 10 and a terminal 80 cut from the terminal strip 8 has been rotated to the second posture by the rotating disc 10; Figure 13 shows an illustrative view of a terminal plugging system according to an exemplary embodiment of the present invention, in which the grasping device 4 grasps the terminal 80 that has been rotated to the second posture by the rotating disk 10 and plugs the grasped terminal 80 into the circuit board 9; Figure 14 shows an illustrative view of a terminal plugging system according to an exemplary embodiment of the present invention, in which a terminal 80 cut from the terminal strip 8 is rotated to a second posture by the rotating disk 10; Figure 15 shows an illustrative view of a terminal plugging system according to an exemplary embodiment of the present invention, in which the conveying device 2 drives the terminal strip 8 to move forward by one pitch to insert the carrier strip part 84 of the first terminal 80 at the front end of the terminal strip 8 into the engagement slot 11 on the rotating disk 10.

As shown in Figures 1 to 15, in an exemplary embodiment of the present invention, a terminal rotating device is disclosed. The terminal rotating device includes a rotating disk 10 and a driving shaft 100. The rotating disk 10 has four engagement slots 11 evenly spaced in its circumferential direction. The driving shaft 100 is connected to the rotating disc 10 for driving the rotating disc 10 to rotate around its central axis. The engagement slot 11 of the rotating disk 10 is suitable for engaging with a carrier strip part 84 on a terminal 80. The rotating disk 10 is used to rotate the terminal 80 engaged with it from a first posture to a second posture perpendicular to the first posture, so as to rotate a plug pin 82 of the terminal 80 from a horizontal orientation to a vertical orientation.

As shown in Figures 1 to 15, in the illustrated embodiment, the engagement slot 11 has an elastic cantilever 12 located on one side, which is used to clamp and fix the carrier strip part 84 of the terminal 80 inserted into the engagement slot 11 in the engagement slot 11.

As shown in Figures 1 to 15, in the illustrated embodiment, an arc-shaped protrusion 12a is formed at the end of the elastic cantilever 12. The arc-shaped protrusion 12a is used to guide the carrier strip part 84 of the terminal 80 into the engagement slot 11 and to rest against the inserted carrier strip part 84.

As shown in Figures 1 to 15, in the illustrated embodiment, a mounting hole 14 is formed in the rotating disk 10, and the end 101 of the driving shaft 100 is inserted into the mounting hole 14 of the rotating disk 10. The cross-section of the mounting hole 14 and the end 101 of the driving shaft 100 is non-circular.

As shown in Figures 1 to 15, in the illustrated embodiment, the terminal rotating device further comprises a driver (not shown, which may be a servo motor) connected to the driving shaft 100 for driving the aforementioned driving shaft 100 to rotate. The driver drives the aforementioned driving shaft 100 to rotate 90 degrees around its central axis each time, in order to rotate the terminal 80 engaged with the rotating disk 10 from the first posture to the second posture perpendicular to the first posture.

As shown in Figures 1 to 15, in an exemplary embodiment of the present invention, a terminal plugging system is also disclosed. The terminal plugging system includes: a terminal rotating device 1, a conveying device 2, a cutting device 3, and a grasping device 4. The terminal rotating device 1 is used to rotate the terminal 80 engaged to it from a first posture to a second posture perpendicular to the first posture. The conveying device 2 is used to transport a terminal strip 8 towards the rotating disc 10 and to insert the carrier strip part 84 of a first terminal 80 at the front end of terminal strip 8 into the engagement slot 11 of rotating disc 10. The cutting device 3 is used to cut off the first terminal 80 at the front end of the terminal strip 8 from the terminal strip 8 and cut off the carrier strip part 84 on the terminal 80 that has been rotated to the second posture by the rotating disk 10. The grasping device 4 is used to grasp the terminal 80 that has been rotated to the second posture and to vertically insert the plug pin 82 of the grasped terminal 80 into a socket 90 in a circuit board 9. The terminal 80 on the terminal strip 8 conveyed by the conveying device 2 is in the first posture, and the plug pin 82 of the terminal 80 is in a horizontal orientation when the terminal 80 is in the first posture. The plug pin 82 of the terminal 80 is in a vertical orientation when the terminal 80 is in the second posture.

As shown in Figures 1 to 15, in the illustrated embodiment, the conveying device 2 includes a conveying gear 20 and a driving motor (not shown). The teeth 20a of the conveying gear 20 mesh with the positioning slots 8a on the terminal strip 8. The driving motor is connected to the conveying gear 20 and is used to drive the rotation of the conveying gear 20. The terminal strip 8 is suitable for moving in a predetermined conveying direction under the drive of the conveying gear 20, and the tooth pitch between adjacent two teeth 20a on the conveying gear 20 is equal to the spacing (or pitch) between adjacent two terminals 80 on the terminal strip 8.

As shown in Figures 1 to 15, in the illustrated embodiment, the conveying device 2 further comprises a conveying channel (not shown) extending along a predetermined conveying direction for guiding the terminal strip 8 to move in the predetermined conveying direction. The terminal strip 8 is positioned in a movable manner in the conveyor channel, so that the terminals 80 on the conveyed terminal strip 8 are in the first posture.

As shown in Figures 1 to 15, in the illustrated embodiment, the cutting device 3 comprises a cutting tool 30 located on one side of the rotating disk 10 and having a first cutting part 31 and a second cutting part 32. The cutting tool 30 can move relative to the rotating disc 10 between an initial position and a cutting position. When the cutting tool 30 is moved to the cutting position, the first cutting part 31 cuts off the first terminal 80 at the front end of the terminal strip 8 from the terminal strip 8, while the second cutting part 32 cuts off the carrier strip part 84 on the terminal 80 that has been rotated to the second posture by the rotating disk 10.

As shown in Figures 1 to 15, in the illustrated embodiment, before the cutting tool 30 is moved to the cutting position, the grasping device 4 grasps the terminal 80 that has been rotated to the second posture by the rotating disk 10 to ensure that the terminal 80 remains stationary when cutting the carrier strip part 84 on the terminal 80.

As shown in Figures 1 to 15, in the illustrated embodiment, the cutting device 3 further comprises a driving mechanism (not shown, for example, a cylinder), which is connected to the cutting tool 30. The driving mechanism is used to drive the cutting tool 30 to move between the initial position and the cutting position.

As shown in Figures 1 to 15, in the illustrated embodiment, a positioning post 33 is formed on the cutting tool 30, and a positioning hole 13 that cooperates with the positioning post 33 is formed in the rotating disc 10. The central axis of the positioning hole 13 is parallel to the central axis of the rotating disc 10 to ensure that the cutting tool 30 moves in a direction parallel to the central axis of the rotating disc 10.

As shown in Figures 1 to 15, in the illustrated embodiment, the terminal plugging system further comprises an elastic pressing device 5, which is located on the other side of the rotating disk 10 opposite to the cutting tool 30. During the cutting process of cutting tool 30, the front end of terminal strip 8 will deviate from its initial position under the push of cutting tool 30. The elastic pressing device 5 is pressed against the second terminal 80 at the front end of the terminal strip 8 to ensure that after the first terminal 80 at the front end of the terminal strip 8 is cut off from the terminal strip 8 by the first cutting part 31, the front end of the terminal strip 8 can automatically reset to the initial position under the push of the elastic pressing device 5.

As shown in Figures 1 to 15, in the illustrated embodiment, the elastic pressing device 5 includes a pushing block 50 and a reset spring 51. The pushing block 50 presses against the second terminal 80 at the front end of terminal strip 8. The reset spring 51 exerts an elastic reset force on the pushing block 50.

As shown in Figures 1 to 15, in the illustrated embodiment, the terminal plugging system further includes a waste recycling device 6 for recycling the carrier strip part 84 cut from the terminal 80.

As shown in Figures 1 to 15, in the illustrated embodiment, the waste recycling device 6 includes a vacuum adsorber 60 and a waste conveying pipe 63. The vacuum adsorber 60 has a compressed air inlet 62, a compressed air outlet, and a vacuum suction port 61. The waste conveying pipe 63 is connected to the compressed air outlet of the vacuum adsorber 60. The vacuum suction port 61 faces the carrier strip part 84 on the terminal 80 that has been rotated to the second posture, so that the carrier strip part 84 cut from the terminal 80 can be sucked into the vacuum adsorber 60, and the sucked carrier strip part 84 is transported to the waste recycling bin (not shown) through the waste conveying pipe 63.

As shown in Figures 1 to 15, in the illustrated embodiment, the second cutting part 32 of the cutting tool 30 is used to cut off the carrier strip part 84 on the terminal 80 and to push the already cut carrier strip part 84 into the vacuum suction port 61 of the vacuum adsorber 60.

As shown in Figures 1 to 15, in the illustrated embodiment, the vacuum adsorber 60 is mounted to a fixed seat, and the reset spring 51 is compressed between the vacuum adsorber 60 and the pushing block 50.

As shown in Figures 1 to 15, in the illustrated embodiment, the terminal plugging system further comprises a position holding device 7, which is adapted to move between a release position and a holding position. When it is not necessary to rotate the aforementioned rotating disc 10, the position holding device 7 is moved to the holding position to hold the rotating disc 10 at a predetermined angle position. When it is necessary to rotate the aforementioned rotating disc 10, the position holding device 7 is moved to the release position to allow the rotating disc 10 to rotate.

As shown in Figures 1 to 15, in the illustrated embodiment, the position holding device 7 includes a brake block 70 and a brake spring 71. The brake block 70 is suitable for frictional engagement with the driving shaft 100. The brake spring 71 applies braking force to the brake block 70. When the position holding device 7 is moved to the holding position, the brake block 70 is pressed against the driving shaft 100 to prevent the driving shaft 100 and the rotating disc 10 from being rotated.

As shown in Figures 1 to 15, in the illustrated embodiment, the grasping device 4 includes a gripper 40 and a moving mechanism (not shown). The gripper 40 is suitable for gripping and grasping the terminal 80 that has been rotated to the second posture by the rotating disk 10. The moving mechanism is used to move the gripper 40 and the terminal 80 grabbed by the gripper 40.

As shown in Figures 1 to 15, in the illustrated embodiment, the aforementioned moving mechanism can be a three-axis translation mechanism or a multi degree of freedom robot.

As shown in Figures 1 to 15, in the illustrated embodiment, the terminal 80 includes a plate-shaped body 83, a mating pin 81, and a plug pin 82. The mating pin 81 is connected to the plate-shaped body 83 for mating with a mating terminal (not shown). The plug pin 82 is connected to the plate-shaped body 83 and is used to plug into the socket 90 on the circuit board 9. The extension direction of the mating pin 81 is perpendicular to the extension direction of the plug pin 82, so that the terminal 80 is L-shaped. The grasping device 4 grasps the terminal 80 by clamping the plate-shaped body 83 of the terminal 80, and the carrier strip part 84 is connected to the plate-shaped body 83 of the terminal 80.

The working process of the terminal plugging system illustrated in the figure will be described below.

Firstly, as shown in Figures 2 and 12, the grasping device 4 grasps the terminal 80 that has been rotated to the second posture by the rotating disk 10;

Then, as shown in Figure 2 and Figure 12, the cutting tool 30 cuts the first terminal 80 at the front end of the terminal strip 8 from the terminal strip 8, and at the same time cuts off the carrier strip part 84 on the terminal 80 that has been rotated to the second posture by the rotating disk 10;

Then, as shown in Figure 13, the grasping device 4 moves the grasped terminal 80 along a pre-planned path to insert the plug pin 82 of the grasped terminal 80 into the socket 90 in the circuit board 9 in the vertical direction; Meanwhile, as shown in Figure 14, the rotating disc 10 is rotated 90 degrees to rotate a terminal 80 cut from the terminal strip 8 from the first posture to the second posture;

Then, as shown in Figure 15, the conveying device 2 moves the terminal strip 8 forward by one pitch to insert the first terminal 80 at the front end of the terminal strip 8 into the engagement slot 11 of the rotating disk 10 aligned with the terminal strip 8;

Then, repeat the previous steps.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A terminal rotating device, comprising:
a rotating disc (10) with four evenly spaced engagement slots (11) distributed in its circumferential direction; and
a driving shaft (100), connected to the rotating disc (10), for driving the rotating disc (10) to rotate around its central axis,
wherein the engagement slot (11) of the rotating disk (10) is adapted to engage with a carrier strip part (84) on a terminal (80), and the rotating disk (10) is used to rotate the terminal (80) engaged with it from a first posture to a second posture perpendicular to the first posture, so as to rotate a plug pin (82) of the terminal (80) from a horizontal orientation to a vertical orientation.

2. The terminal rotating device according to claim 1,
wherein the engagement slot (11) has an elastic cantilever (12) located on one side, which is used to clamp and fix the carrier strip part (84) of the terminal (80) inserted into the engagement slot (11) in the engagement slot (11);
and/or
wherein an arc-shaped protrusion (12a) is formed at the end of the elastic cantilever (12), which is used to guide the carrier strip part (84) of the terminal (80) into the engagement slot (11) and to rest against the inserted carrier strip part (84).

3. The terminal rotating device according to claim 1,
wherein a mounting hole (14) is formed in the rotating disk (10), and the end (101) of the driving shaft (100) is inserted into the mounting hole (14) of the rotating disk (10), and the cross-section of the mounting hole (14) and the end (101) of the driving shaft (100) is non-circular;
and/or
wherein the terminal rotating device further comprises:
a driver connected to the driving shaft (100) for driving the driving shaft (100) to rotate,
wherein the driver drives the driving shaft (100) to rotate 90 degrees around its central axis each time, to rotate the terminal (80) engaged with the rotating disk (10) from the first posture to the second posture perpendicular to the first posture.

4. A terminal plugging system, comprising:
the terminal rotating device (1) according to any one of claims 1-3, used for rotating a terminal (80) engaged to it from a first posture to a second posture perpendicular to the first posture;
a conveying device (2) for conveying a terminal strip (8) towards the rotating disk (10) and inserting the carrier strip part (84) of a first terminal (80) at the front end of the terminal strip (8) into the engagement slot (11) of the rotating disk (10);
a cutting device (3) for cutting off the first terminal (80) at the front end of the terminal strip (8) from the terminal strip (8) and cutting off the carrier strip part (84) on the terminal (80) that has been rotated to the second posture by the rotating disk (10); and
a grasping device (4) which is used to grasp the terminal (80) that has been rotated to the second posture and to vertically insert the plug pin (82) of the grasped terminal (80) into a socket (90) in a circuit board (9),
wherein the terminal (80) on the terminal strip (8) conveyed by the conveying device (2) is in the first posture, and the plug pin (82) of the terminal (80) is in a horizontal orientation when the terminal (80) is in the first posture, and the plug pin (82) of the terminal (80) is in a vertical orientation when the terminal (80) is in the second posture.

5. The terminal plugging system according to claim 4,
wherein the conveying device (2) comprises:
a conveying gear (20) with teeth (20a) for meshing with the positioning slots (8a) on the terminal strip (8); and
a drive motor, connected to the conveying gear (20), for driving the conveying gear (20) to rotate,
wherein the terminal strip (8) is adapted to be moved in a predetermined conveying direction under the drive of the conveying gear (20), and the tooth pitch between adjacent two teeth (20a) on the conveying gear (20) is equal to the spacing between adjacent two terminals (80) on the terminal strip (8);
and/or
wherein the conveying device (2) further comprises:
a conveying channel extending along the predetermined conveying direction, used to guide the terminal strip (8) to move along the predetermined conveying direction,
wherein optionally the terminal strip (8) is positioned in a movable manner in the conveying channel, such that the terminals (80) on the conveyed terminal strip (8) are in the first posture.

6. The terminal plugging system according to claim 4,
wherein the cutting device (3) comprises:
a cutting tool (30) located on one side of the rotating disk (10) and having a first cutting part (31) and a second cutting part (32),
wherein the cutting tool (30) can be moved relative to the rotating disk (10) between an initial position and a cutting position,
wherein when the cutting tool (30) is moved to the cutting position, the first cutting part (31) cuts off the first terminal (80) at the front end of the terminal strip (8) from the terminal strip (8), while the second cutting part (32) cuts off the carrier strip part (84) on the terminal (80) that has been rotated to the second posture by the rotating disk (10);
and/or
wherein before the cutting tool (30) is moved to the cutting position, the grasping device (4) grasps the terminal (80) that has been rotated to the second posture by the rotating disk (10) to ensure that the terminal (80) remains stationary when cutting off the carrier strip part (84) on the terminal (80).

7. The terminal plugging system according to claim 6,
wherein the cutting device (3) further comprises:
a driving mechanism which is connected to the cutting tool (30),
wherein the driving mechanism is used to drive the cutting tool (30) to move between the initial position and the cutting position;
and/or
wherein a positioning post (33) is formed on the cutting tool (30), and a positioning hole (13) that cooperates with the positioning post (33) is formed in the rotating disk (10); the central axis of the positioning hole (13) is parallel to the central axis of the rotating disk (10) to ensure that the cutting tool (30) is moved in a direction parallel to the central axis of the rotating disk (10).

8. The terminal plugging system according to claim 6, further comprising:
an elastic pressing device (5) located on the other side of the rotating disk (10) opposite to the cutting tool (30),
wherein the elastic pressing device (5) is pressed against a second terminal (80) at the front end of the terminal strip (8) to ensure that after the first terminal (80) at the front end of the terminal strip (8) is cut off from the terminal strip (8) by the first cutting part (31), the front end of the terminal strip (8) can automatically reset under the push of the elastic pressing device (5).

9. The terminal plugging system according to claim 8,
wherein the elastic pressing device (5) comprises:
a pushing block (50) which is pressed against the second terminal (80) at the front end of the terminal strip (8); and
a reset spring (51) which applies an elastic reset force on the pushing block (50);
and/or
wherein the terminal plugging system further comprises:
a waste recycling device (6) for recycling the carrier tape part (84) cut from the terminal (80).

10. The terminal plugging system according to claim 9,
wherein the waste recycling device (6) comprises:
a vacuum adsorber (60) with a compressed air inlet (62), a compressed air outlet, and a vacuum suction port (61); and
a waste conveying pipe (63) which is connected to the compressed air outlet of the vacuum adsorber (60),
wherein the vacuum suction port (61) faces the carrier strip part (84) on the terminal (80) that has been rotated to the second posture, so that the carrier strip part (84) cut from the terminal (80) can be sucked into the vacuum adsorber (60), and the sucked carrier strip part (84) is transported to a waste recycling bin through the waste conveying pipe (63).

11. The terminal plugging system according to claim 10,
wherein the second cutting part (32) of the cutting tool (30) is used to cut off the carrier strip part (84) on the terminal (80) and to push the cut carrier strip part (84) into the vacuum suction port (61) of the vacuum adsorber (60);and/or
wherein the vacuum adsorber (60) is installed on a fixed seat, and the reset spring (51) is compressed between the vacuum adsorber (60) and the pushing block (50).

12. The terminal plugging system according to claim 4, further comprising:
a position holding device (7) adapted to be moved between a release position and a holding position,
wherein when it is not necessary to rotate the rotating disc (10), the position holding device (7) is moved to the holding position to hold the rotating disc (10) at a predetermined angular position;
wherein when it is necessary to rotate the rotating disc (10), the position holding device (7) is moved to the release position to allow the rotating disc (10) to rotate.

13. The terminal plugging system according to claim 12,
wherein the position holding device (7) comprises:
a brake block (70), suitable for frictional engagement with the driving shaft (100); and
a brake spring (71) which applies braking force to the brake block (70),
wherein when the position holding device (7) is moved to the holding position, the brake block (70) is pressed against the driving shaft (100) to prevent rotation of the driving shaft (100) and the rotating disc (10).

14. The terminal plugging system according to claim 4,
wherein the grasping device (4) comprises:
a gripper (40) suitable for gripping and grasping a terminal (80) that has been rotated to the second posture by the rotating disk (10); and
a moving mechanism used to move the gripper (40) and the terminal (80) grabbed by the gripper (40);
and/or
wherein the moving mechanism is a three-axis translation mechanism or a multi degree of freedom robot.

15. The terminal plugging system according to any one of claims 4-14,
wherein the terminal (80) comprises:
a plate-shaped body (83);
a mating pin (81) which is connected to the plate-shaped body (83) for mating with a mating terminal (80); and
a plug pin (82) which is connected to the plate-shaped body (83) and used to plug into a socket (90) in a circuit board (9),
wherein the extension direction of the mating pin (81) is perpendicular to the extension direction of the plug pin (82), so that the terminal (80) is L-shaped, the grasping device (4) grasps the terminal (80) by clamping the plate-shaped body (83) of the terminal (80), and the carrier strip part (84) is connected to the plate-shaped body (83) of the terminal (80).
